# EUROPEAN PATENT APPLICATION

(11) **EP 4 671 797 A1**
(43) Date of publication of application: **31.12.2025**
(21) Application number: 25185509.4
(22) Date of filing: 26.06.2025
(51) Int. Cl.: G01R 31/392, G01R 31/396, H01M 10/42, H01M 10/48

(54) **METHOD AND APPARATUS FOR MONITORING SELF-DISCHARGE PHENOMENA OF ELECTROCHEMICAL CELLS**

(30) Priority: 28.06.2024 IT 202400014938
(71) Applicant: FERRARI S.p.A., 41100 Modena (IT)
(72) Inventor: LUZI, Massimiliano, 41100 MODENA (IT); ZAMPOLINI, Federico, 41100 MODENA (IT); SHANG, Congcong, 41100 MODENA (IT)
(74) Representative: Studio Torta S.p.A.

(57) **Abstract**

A method for monitoring self-discharge phenomena of electrochemical cells, comprising the steps of: a) providing a plurality of electrochemical cells (2), wherein each cell (2) has a first dimension and a second dimension, extending respectively along a first direction (X) and a second direction (Y) orthogonal to one another, greater than a third dimension extending along a third direction (Z) orthogonal to the first direction (X) and the second direction (Y), wherein each cell (2) comprises a casing (3) and a plurality of layers arranged inside the casing (3), wherein the layers comprise at least one first electrode layer, at least one second electrode layer and at least one first separator layer interposed between the first electrode layer and the second electrode layer; b) arranging the cells (2) so that a straight line (L) extending along the third direction (Z) intersects the cells (2); c) compressing the cells (2) along the third direction (Z); d) measuring a voltage of each cell (2) of the plurality of cells (2) to detect whether a self-discharge value of said cell (2) is greater than a predetermined threshold, wherein step c) is prior to or at least partially simultaneous with step d), and step d) is prior to a step of assembling the cells (2) into one or more batteries. Figure 1

## Description

### CROSS-REFERENCE TO RELATED APPLICATIONS

This patent application claims priority from Italian patent application no. 102024000014938 filed on June 28, 2024, the entire disclosure of which is incorporated herein by reference.

### TECHNICAL FIELD

The invention relates to a method for monitoring self-discharge phenomena of electrochemical cells and to an apparatus for monitoring self-discharge phenomena of electrochemical cells.

In particular, the invention advantageously, though not exclusively applies to the monitoring of self-discharge phenomena of electrochemical cells to be assembled into one or more batteries or, optionally, into one or more modules of one or more batteries, for a vehicle, in particular for a car, to which explicit reference will be made in the description below without because of this lacking generality. Other applications could lie in the field of storage systems for different solutions, for example from renewable sources such as solar panels, wind, hydroelectric systems, etc.

### PRIOR ART

As it is known, lithium batteries, thanks to their high energy density, allow electric drive systems to be more and more implemented in the automotive industry. In particular, lithium ions currently represent, from a chemical point of view, the state of the art in the production of high-capacity batteries.

A battery comprises a plurality of electrochemical cells. Optionally, a battery comprises a plurality of modules and each module comprises a plurality of cells.

In particular, a battery used in the automotive industry can comprise tens, hundreds or thousands of cells.

Each cell comprises a casing and a plurality of layers arranged inside the casing. The layers comprise at least two electrode layers (positive and negative, i.e. cathode and anode) and a separator layer interposed between the two electrode layers, and can comprise tens of electrode layers and separator layers interposed between the electrode layers.

There are different types of cells, for example cylindrical cells, pouch cells, prismatic cells.

In particular, pouch cells and prismatic cells have a first dimension and a second dimension (length and width), extending respectively along a first direction and a second direction orthogonal to one another, which are greater than a third dimension (thickness), extending along a third direction orthogonal to the first direction and to the second direction. The casing of a pouch cell comprises a multilayer pouch, while the casing of a prismatic cell comprises a metal can. Conveniently, the pouch cells are externally shaped like a pouch (or bag) and the prismatic cells are externally shaped like a prism, in particular like a parallelepiped.

The cells are subjected to self-discharge phenomena. In particular, over time a cell tends to decrease its charge (namely, its "state of charge", SoC, simultaneously decreasing its voltage), even if the cell is not used, for example while the cell is stored. In other words, the cells tend to self-discharge.

However, some cells have an abnormal self-discharge, being therefore considered as defective cells. In particular, such defective cells have a self-discharge value that is greater than an expected and/or acceptable self-discharge value.

A possible cause of an abnormal self-discharge is the presence of a metal contamination and/or damage to the separator, causing a contact between the positive and negative electrodes and therefore a short circuit.

Typically, the cells are analyzed after having been manufactured, for example while being stored, to detect any defective cells, i.e. cells having an abnormal self-discharge. In particular, a voltage of each cell is periodically measured to detect whether a self-discharge value of said cell is greater than an expected and/or acceptable self-discharge value, **i.e.** to detect whether said cell has an abnormal self-discharge and is therefore a defective cell. Therefore, if a defective cell is detected, it can be discarded.

Subsequently, the cells are assembled into one or more batteries or, optionally, into one or more modules of one or more batteries. To this aim, the cells are compressed orthogonally to the respective main faces to make them work at their best.

However, some cells can show an abnormal self-discharge, thus being considered as defective cells, only after they have been assembled into one or more batteries or, optionally, into one or more modules of one or more batteries.

A possible cause is the presence of a latent metal contamination and/or latent damage to the separator, i.e. a metal contamination and/or damage to the separator that was already present but had not been detected, for example because it was small and not such as to cause a contact between the positive and negative electrodes and therefore a short circuit in the absence of the compression applied, in use, to the cells inside a respective module or a respective battery.

If a battery (or a module) contains even one defective cell, the entire battery (or the entire module) must be discarded, with obvious economic and environmental drawbacks.

In addition, if the battery (or the module) containing one or more defective cells is mounted on vehicles that are already on the market, it may be necessary to carry out a recall campaign, with obvious economic and image repercussions.

### DESCRIPTION OF THE INVENTION

The object of the invention is to provide a method for monitoring self-discharge phenomena in electrochemical cells and an apparatus for monitoring self-discharge phenomena of electrochemical cells, which are at least partially free from the drawbacks described above and, at the same time, are simple and economic to be manufactured and implemented.

According to the invention, there are provided a method for monitoring self-discharge phenomena in electrochemical cells and an apparatus for monitoring self-discharge phenomena of electrochemical cells as claimed in the independent claims attached hereto and, preferably, in any one of the dependent claims directly or indirectly depending on the independent claims.

The appended claims describe preferred embodiments of the invention and form an integral part of the description.

### BRIEF DESCRIPTION OF THE DRAWINGS

The invention will be best understood upon perusal of the following detailed description of a preferred embodiment, which is provided by way of non-limiting example, with reference to the accompanying drawings, wherein:
- figure 1 is a schematic view of an apparatus and a method according to the invention;
- figure 2 is a perspective view of an apparatus according to the invention;
- figures 3a, 3b, 3c, 3d are schematic perspective views of the apparatus of figure 2 during respective steps of the method;
- figure 4 is a perspective view of a detail of the apparatus of figure 2;
- figure 5 is a front view of a detail of the apparatus of figure 2 and of a cell housed in the apparatus;
- figure 6 is a sectional top view of a detail of the apparatus of figure 2;

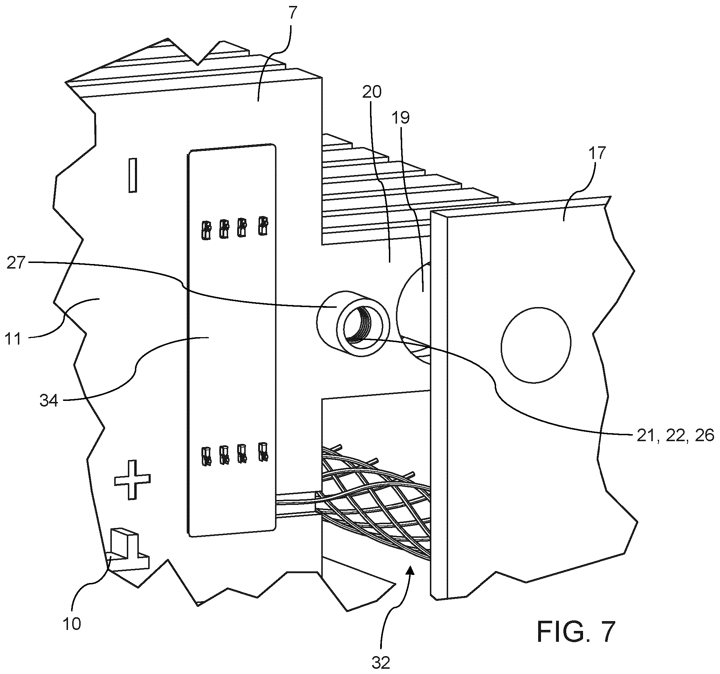

- figure 7 is a perspective view of a detail of the apparatus of figure 2;

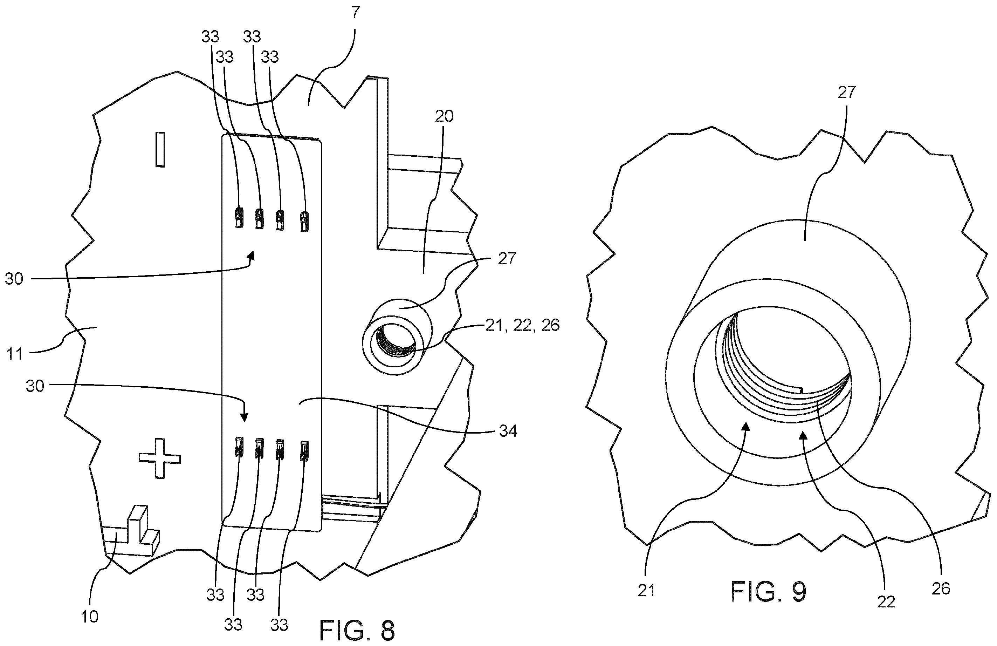

- figures 8 and 9 are perspective views of respective details of the apparatus of figure **2****.**

### EMBODIMENTS OF THE INVENTION

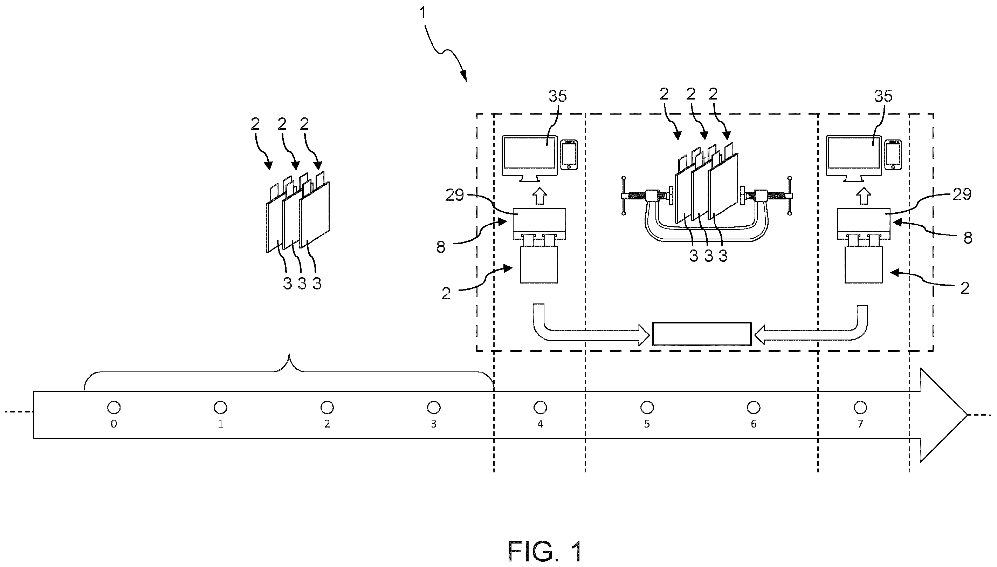

With reference to figure 1, number 1 indicates an apparatus for monitoring self-discharge phenomena of electrochemical cells 2 according to the invention.

The apparatus 1, described in detail below, implements a method for monitoring self-discharge phenomena of electrochemical cells 2 according to the invention.

The method comprises a plurality of steps, described in detail below.

The method comprises a step a) of providing a plurality of electrochemical cells **2,** wherein each cell 2 has a first dimension and a second dimension, extending respectively along a first direction X and a second direction Y orthogonal to one another, which are greater than a third dimension (thickness), extending along a third direction Z orthogonal to the first direction X and to the second direction Y. Each cell comprises a casing 3 and a plurality of layers arranged inside the casing 3. The layers comprise at least one first electrode layer, at least one second electrode layer and at least one first separator layer interposed between the first electrode layer and the second electrode layer.

In particular, the cells 2 comprise planar cells, which comprise cells having planar electrode plates *("blanks").* In particular, the planar cells comprise pouch cells, in which the casing 3 comprises a multilayer pouch, and prismatic cells, in which the casing 3 comprises a metal can. Conveniently, the pouch cells are externally shaped like a pouch (or bag) and the prismatic cells are externally shaped like a prism, in particular like a parallelepiped.

Conveniently, the planar cells comprise so-called "Z-folded" cells (which may be pouch cells or prismatic cells, depending on the type of casing 3), in which the electrode layers are arranged parallel to one another and the separator layer is arranged "zigzag"-like between the electrode layers, thus being interposed between the electrode layers.

Conveniently, one of the first electrode layer and the second electrode layer is a cathode layer and the other one of the first electrode layer and the second electrode layer is an anode layer.

Preferably, each cell 2 comprises a third electrode layer (of the same type, i.e. cathode or anode, as the first electrode layer) and at least one second separator layer interposed between the second electrode layer and the third electrode layer. Conveniently, each cell 2 can comprise tens of electrode layers and separator layers interposed between the electrode layers.

The method comprises a step b) of arranging the cells 2 so that a straight line L extending along the third direction Z intersects the cells 2.

In particular, each cell 2 comprises a first face 4 and a second face 5 opposite the first face 4. Conveniently, each of the first face 4 and the second face 5 substantially extends on a plane defined by the first direction X and by the second direction Y and, therefore, orthogonal to the third direction Z. Conveniently, the first face 4 and the second face 5 are parallel to one another. In step b), the cells 2 are arranged so as to face one another. In particular, considering a first cell 2 and a second cell 2 facing one another, the second face 5 of the first cell 2 faces the first face 4 of the second cell 2 and, therefore, the straight line L extending along the third direction Z intersects the first cell 2 and the second cell 2.

The method comprises a step c) of compressing the cells 2 along the third direction Z.

In particular, the cells 2 are compressed together along the third direction Z, i.e. the distance along the third direction Z between each pair of cells 2 facing one another is reduced. In particular, considering the first cell 2 and the second cell 2 facing one another, the distance along the third direction Z between the second face 5 of the first cell 2 and the first face 4 of the second cell 2 is reduced. In particular, for each cell 2, the first electrode layer the second electrode layer and the first separator layer interposed between the first electrode layer and the second electrode layer are compressed.

The method comprises a step d) of measuring a voltage of each cell 2 of the plurality of cells 2 to detect whether a self-discharge value of said cell 2 is above a predetermined threshold.

In particular, for each cell 2, a first voltage value, which is for example a nominal voltage value or a previously measured voltage value, is considered and a second voltage value is measured. Conveniently, the first voltage value is greater than or equal to the second voltage value and typically greater than the second voltage value. Conveniently, the self-discharge value of each cell 2 is correlated to the comparison between the first voltage value and the second voltage value, in particular to the difference (for example, measured in mV) between the first voltage value and the second voltage value. Preferably, the self-discharge value of each cell 2 is also correlated to the time distance (for example, calculated in days) between the first voltage value (i.e. an instant associated with the first voltage value) and the second voltage value (i.e. an instant associated with the second voltage value). For example, the self-discharge value of each cell 2 is the ratio between the difference between said difference and said time distance.

Conveniently, the predetermined threshold corresponds to a maximum expected and/or acceptable self-discharge value.

Conveniently, if the self-discharge value of a specific cell 2 is greater than the predetermined threshold, an abnormal self-discharge is detected for said cell 2, i.e. the self-discharge of said cell 2 is greater than expected and/or acceptable.

Step c) is prior to or at least partially simultaneous with step d), and step d) is prior to a step of assembling the cells into one or more batteries.

In particular, there is no time overlap between step c) and step d), or there is at least a partial time overlap between step c) and step d).

In other words, when step d) is performed, it is no longer true that the cells 2 are compressed along the third direction Z, i.e. the cells 2 are no longer compressed along the third direction Z, or there is a time interval in which step d) is performed and the cells 2 are compressed along the third direction Z.

Step d) is prior to a step of assembling the cells 2 into one or more batteries.

In particular, when step d) is performed, the cells 2 are not assembled (yet) into one or more batteries or, optionally, into one or more modules of one or more batteries.

In other words, the cells 2 are (optionally) assembled into one or more batteries or, optionally, into one or more modules of one or more batteries after step d).

Preferably, the method comprises a step e), prior to step c), of measuring a voltage of each cell 2 of the plurality of cells 2, wherein step d) comprises comparing the voltages measured in step e) with respective voltages measured in step d) to detect whether a self-discharge value of said cell 2 is above a predetermined threshold.

In particular, step e) is prior to step c) and, for example, prior to step b).

In other words, when step e) is performed, the cells 2 have not yet been compressed along the third direction Z, and for example have not yet been arranged so that the straight line L extending along the third direction Z intersects the cells 2.

Conveniently, in step e), said first voltage value is measured, which is a voltage value measured prior to step d), in which the second voltage value is measured. Conveniently, the self-discharge value of each cell 2 is correlated to said comparison between the first voltage value, measured during step e), and the second voltage value, measured during step d).

Preferably, step c) has a duration greater than a predetermined period.

In particular, the cells 2 are compressed along the third direction Z for a duration longer than the predetermined period, i.e. the cells 2 are kept compressed together at least for the predetermined period. For example, the predetermined period is a plurality of days, for example two days. For each type of cell 2, based on the respective mechanical or electrical characteristics, it is possible to empirically establish, in order to optimise the monitoring thereof, different timing (in terms of duration of the observation) and precision of the measuring instruments.

Preferably, step c) comprises exerting a compressive force between a first predetermined threshold and a second predetermined threshold.

In particular, the compressive force exerted during step c) to compress the cells 2 along the third direction Z is greater than the first predetermined threshold and smaller than the second predetermined threshold.

Preferably, the first predetermined threshold is greater than or equal to a compressive force to which the cells 2 will be subjected when they will be assembled into one or more batteries or, optionally, into one or more modules of one or more batteries and will begin to be used. In other words, the first predetermined threshold is greater than or equal to a compressive force to which the cells 2 will be subjected in the instant of "start of life" of the batteries.

For example, the first predetermined threshold is 2000 N.

Conveniently, the second predetermined threshold is smaller than a maximum compressive force the cells 2 can withstand. Conveniently, the maximum compressive force the cells 2 can withstand depends on the type of cells 2.

Preferably, the method comprises the step of discarding each cell 2 such that the self-discharge value of said cell 2 is above said predetermined threshold.

In particular, if in step d) it is detected that the self-discharge value of a specific cell 2 is greater than the predetermined threshold, said cell 2 is discarded, i.e. it is removed from the plurality of cells 2. Conveniently, said cell 2 is replaced with another cell 2.

Figure 1 shows a non-limiting example of the method, considering a manufacturer of cells 2, namely a company that manufactures cells 2 to supply them to a user of cells 2. Conveniently, the time unit (indicated on the time arrow) is one day.

In particular, the cells 2 are manufactured on day 0, and left for four days without being compressed, for example while being stored. On day 4, the aforementioned first voltage value of each cell 2 (step e)) is measured. On the following two days (days 5 and 6)**,** the cells 2 are arranged so that the straight line L extending along the third direction Z intersects the cells (step b)), and are compressed along the third direction Z, for example while being stored (step c)). On day 7, the aforementioned second voltage value of each cell 2 is measured (step d)) to detect whether a self-discharge value of said cell 2 is above a predetermined threshold. Conveniently, if it is detected that the self-discharge value of a specific cell 2 is greater than the predetermined threshold, said cell 2 is discarded, i.e. it is removed from the plurality of cells 2.

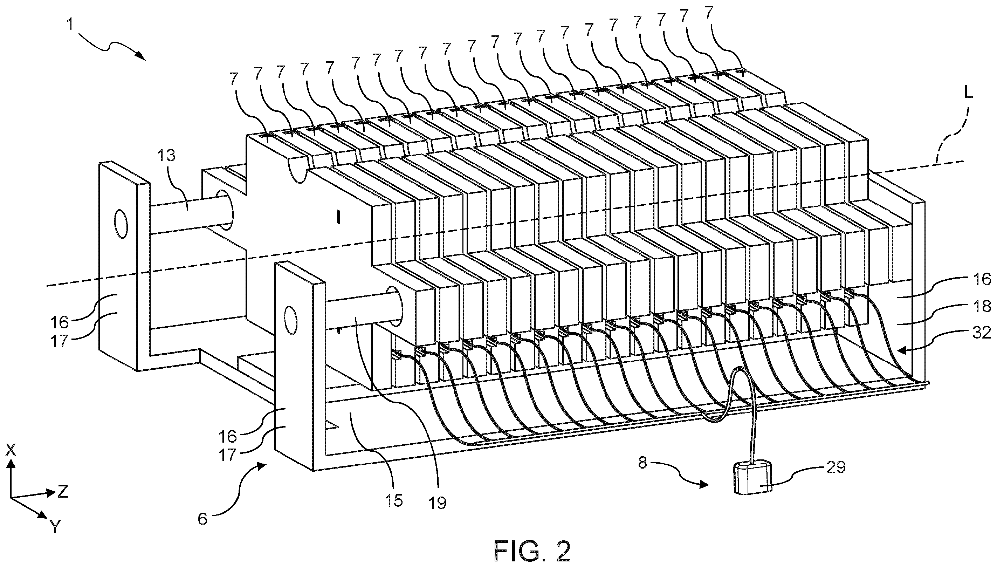

Figures 2 and following show a non-limiting examples of an apparatus 1 according to the invention.

The apparatus 1 comprises a support structure 6 and a plurality of plates 7 configured to carry a plurality of electrochemical cells 2 described above, and a detection system 8.

In the non-limiting embodiment shown herein, the cells 2 are pouch cells.

Each plate 7 has a first dimension and a second dimension, extending respectively along the aforementioned first direction X and the aforementioned second direction Y, which are greater than a third dimension (thickness) extending along the aforementioned third direction Z. The plates 7 are carried by the support structure 6 so that a straight line L extending along the third direction Z intersects the plates 7.

The detection system 8 is configured to measure a voltage of each cell 2 of the plurality of cells 2 to detect whether a self-discharge value of said cell 2 is above a predetermined threshold.

The apparatus 1 is configured to assume a first configuration, in which the plates 7 are not compressed along the third direction Z, and a second configuration, wherein the plates 7 are compressed along the third direction Z.

In particular, the first configuration is a rest configuration, in which the plates 7 and therefore the cells 2 are not compressed along the third direction Z, and the second configuration is a compression configuration, in which the plates 7 and therefore the cells 2 are compressed along the third direction Z.

Conveniently, the first dimension of the plates 7 is greater than the first dimension of the cells 2, the second dimension of the plates 7 is greater than the second dimension of the cells 2, the third dimension of the plates 7 is greater than the third dimension of the cells 2.

Preferably, each plate 7 is configured to house a respective cell 2 of said cells 2, i.e. of the plurality of cells 2.

In particular, each plate 7 is configured to carry one single cell 2, in particular to house said cell 2.

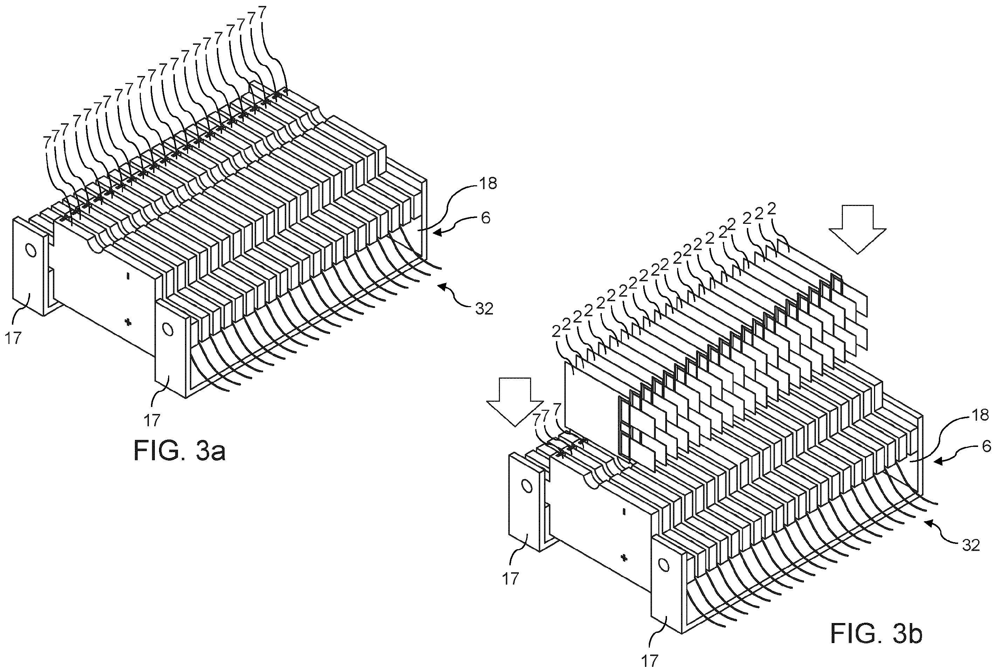

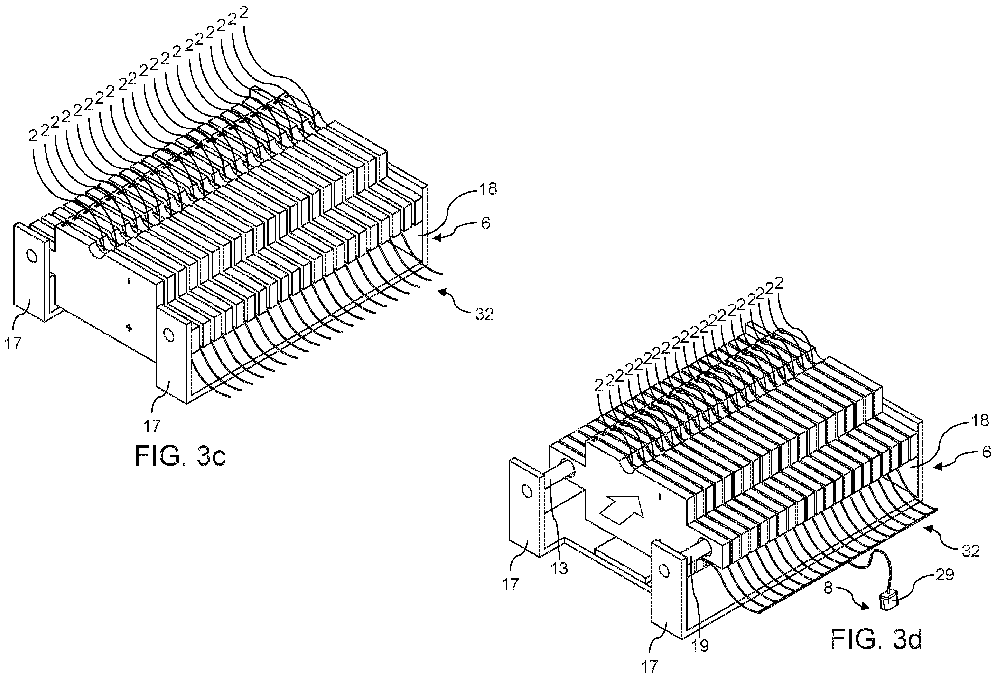

Conveniently (figure 3b), each cell 2 can be inserted into the respective plate 7 and removed from the respective plate 7, for example by means of a rigid translation on a plane orthogonal to the third direction Z. Conveniently, the insertion of each cell 2 into the respective plate 7 and/or the removal of each cell 2 from the respective plate 7 takes place manually or automatically. When a cell 2 is inserted into the respective plate 7 (figure 3c), said cell 2 moves together with the respective plate 7 (figure 3d).

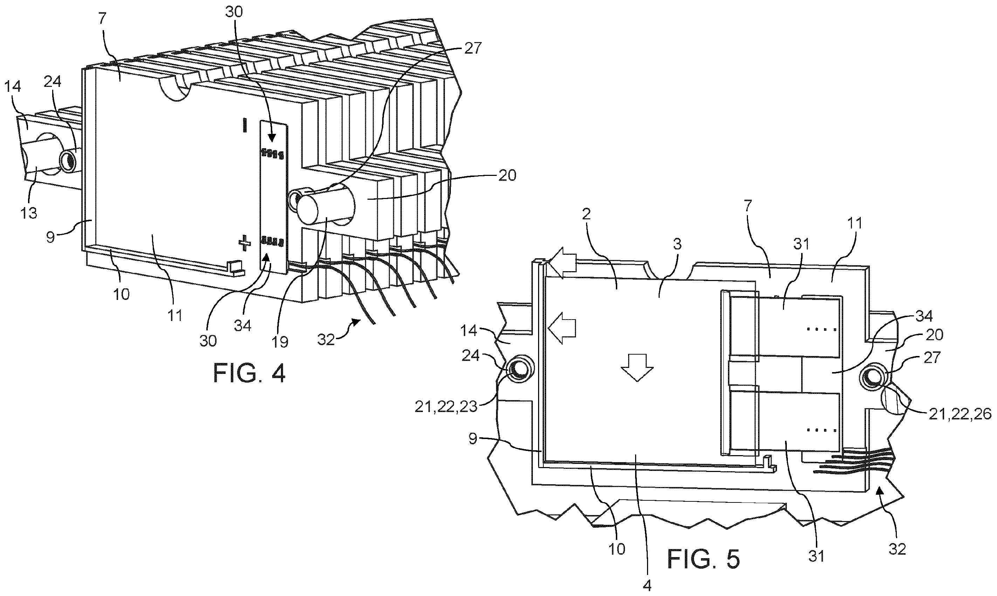

Preferably (figures 4 and 5), each plate 7 comprises a first projection 9 extending along the first direction X and a second projection 10 extending along the second direction Y. The first projection 9 and the second projection 10 are jointly configured to house a respective cell 2 of said cells 2 and define the position of said cell 2 relative to said plate 7.

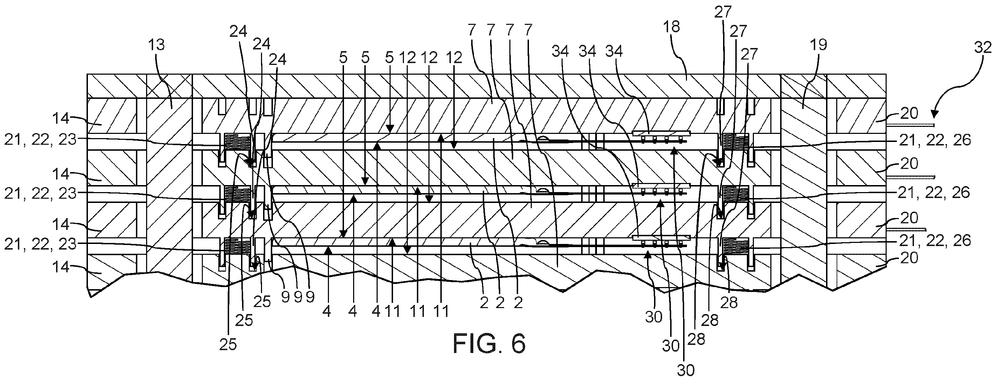

In particular (figure 6), each plate 7 comprises a first face 11 and a second face 12 opposite the first face 11. Conveniently, each of the first face 11 and the second face 12 substantially extends on a plane defined by the first direction X and by the second direction Y and, therefore, orthogonal to the third direction Z. Conveniently, the first face 11 and the second face 12 are parallel to one another. Conveniently, the plates 7 are arranged so as to face one another. In particular, considering a first plate 7 and a second plate 7 facing one another, the second face 12 of the first plate 7 faces the first face 11 of the second plate 7 and, therefore, the straight line L extending along the third direction Z intersects the first plate 7 and the second plate 7.

Conveniently, the first projection 9 and the second projection 10 are arranged on a same face of each plate 7, for example on the first face 11. This face is the one with which the respective cell 2 is in contact, when said cell 2 is housed in the respective plate 7. Conveniently, the contact of the cell 2 with the first projection 9 and the second projection 10 of the respective plate 7 defines the unique position of said cell 2 relative to said plate 7. In other words, the first projection 9 and the second projection 10 define respective limit stops for the respective cell **2.**

Preferably (figures 4 and 5), the first projection 9 and the second projection 10 are in contact with one another, i.e. they jointly define an L-shaped structure.

Conveniently (figure 6), the first projection 9 and the second projection 10 of each plate 7 define ribs on the first face 11 to which respective grooves correspond on the second face 12 of the plate 7 facing said plate 7, so that the cell 2 can be compressed between the first face 11 and the second face 12 of two plates 7 facing one another. For example, the first projection 9 and the second projection 10 of the first face 11 of the aforementioned second plate 7 correspond to respective grooves on the second face 12 of the aforementioned first plate 7, which faces the first face 11 of the second plate 7, so that the cell 2 carried by the second plate 7 can be compressed between the first plate 7 and the second plate 7, in particular between the first face 11 of the second plate 7 and the second face 12 of the first plate 7.

Preferably, each plate 7 is coupled to the support structure 6 in a sliding manner.

In particular, each plate 7 is carried by the support structure 6 and can slide relative to the support structure 6. Conveniently, each plate 7 can slide relative to the support structure 6 along the third direction Z. In other words, the relative position between each plate 7 (and therefore the respective cell 2, when inserted) and the support structure 6 along the third direction Z is variable. Preferably, the relative position between each plate 7 (and therefore the respective cell 2, when inserted) and the support structure 6 along the first direction X and along the second direction Y is fixed. Preferably, the relative orientation between each plate 7 (and therefore the respective cell 2, when inserted) and the support structure 6 is fixed.

Preferably (figure 2), the support structure 6 comprises at least one first elongated element 13 extending along the third direction Z and each plate 7 comprises at least one first appendage 14 coupled to the first element 13 in a sliding manner.

In particular, the support structure 6 comprises a base 15, for example extending on a plane orthogonal to the third direction Z, and a plurality of bearing elements 16 extending from the base 15 and configured to carry at least the first element 13.

Preferably, each first appendage 14 has a respective through hole configured to be engaged by the first element 13, so that the respective plate 7 can slide relative to the support structure 6, in particular relative to the first element 13, along the third direction Z.

In the non-limiting embodiment shown herein, the support elements 17 comprise two beams 17 substantially extending along the first direction X and a support plate 18 extending on a plane orthogonal to the third direction Z. The plates 7 are interposed, along the third direction Z, between the beams 17 and the support plate 18 and are interposed, along the second direction Y, between the beams 17. Conveniently, the first element 13 is carried by and interposed, along the third direction Z, between one of the beams 17 and the support plate 18.

Preferably, the support structure 6 comprises a second elongated element 19 extending along the third direction Z and each plate 7 comprises at least one second appendage 20 coupled to the second element 19 in a sliding manner.

In the non-limiting embodiment shown herein, the second element 19 is carried by and interposed, along the third direction Z, between the other one of the beams 17 (relative to the beam 17 of the first element 13) and the support plate 18.

Preferably, each second appendage 20 has a respective through hole configured to be engaged by the second element 19, so that the respective plate 7 can slide relative to the support structure 6, in particular relative to the second element 19, along the third direction Z.

In the non-limiting embodiment shown herein, the first element 13 and the second element 19 are cylindrical elements, whose respective axes extend along the third direction Z.

Preferably (figures 5 and following), the apparatus 1 comprises restoring means 21 configured to restore the apparatus 1 from the second configuration to the first configuration.

In particular, the restoring means 21 are configured to restore the apparatus 1 to the first configuration, which is a rest configuration, when the apparatus 1 is in the second configuration, which is a compression configuration. Conveniently, the restoring means 21 are configured to restore the apparatus 1 to the first configuration, i.e. to space the plates 7 apart from one another, when the plates 7 are not (no longer) compressed along the third direction Z.

Preferably, the restoring means 21 comprise elastic means.

Preferably, the restoring means 21 comprise springs 22 extending along the third direction Z and carried by the plates 7.

In particular, the aforementioned elastic means comprise the springs 22. Conveniently, each plate 7 carries a first spring 23. In other words, the springs 22 comprise a respective first spring 23 for each plate 7.

For example, each plate 7 comprises a first tubular appendage 24, whose axis extends along the third direction Z. Conveniently, the first tubular appendage 24 is configured to house the first spring 23, which is for example a helical compression spring, whose axis extends along the third direction Z.

In the non-limiting embodiment shown herein, the first tubular appendage 24 of each plate 7 is arranged on the first face 11, in particular on the first appendage 14 of the plate 7, which corresponds to a first tubular recess 25 on the second face 12 of the plate 7 facing said plate 7. For example, the first tubular appendage 24 of the first face 11 of the aforementioned second plate 7 corresponds to a respective first tubular recess 25 on the second face 12 of the aforementioned first plate 7, which faces the first face 11 of the second plate 7.

Preferably, each plate 7 carries a second spring 26. In other words, the springs 22 comprise a respective second spring 26 for each plate 7.

In particular, the springs 22 are configured to permit the adjustment of the compressive force applicable to the cells 2 (and designed according to the type of cells 2 to be analysed) .

For example, each plate 7 comprises a second tubular appendage 27, whose axis extends along the third direction Z. Conveniently, the second tubular appendage 27 is configured to house the second spring 26, which is for example a helical compression spring, whose axis extends along the third direction Z.

In the non-limiting embodiment shown herein, the second tubular appendage 27 of each plate 7 is arranged on the first face 11, in particular on the second appendage 20 of the plate 7, which corresponds to a second tubular recess 28 on the second face 12 of the plate 7 facing said plate 7. For example, the second tubular appendage 27 of the first face 11 of the aforementioned second plate 7 corresponds to a respective first tubular recess 28 on the second face 12 of the aforementioned first plate 7, which faces the first face 11 of the second plate 7.

Preferably, the detection system 8 comprises at least one voltage meter 29 configured to measure a voltage of each cell 2 of the plurality of cells 2, and a plurality of electrical contacts 30 configured to be in contact with terminal poles 31 of the cells 2 and electrically connected to said at least one voltage meter 29**.**

In particular, each cell 2 comprises at least two terminal poles 31 (positive and negative, **i.e.** cathode and anode) arranged on the same side of the cell **2,** like in the non-limiting embodiment shown herein, or arranged on opposite sides of the cell 2. When the cell 2 is housed in the plate **7,** the cell 2 is electrically connected to said at least one voltage meter 29, since the two terminal poles 31 are in contact with the electrical contacts 30**,** which are electrically connected to said at least one voltage meter 29 through electrical cables 32**.** Obviously, the number and the arrangement of the terminals 31 can vary based on the configuration of the cell 2 to be tested (for example, there could be a greater number of terminals and/or these could be arranged on different sides of the cell 2).

For instance, the voltage meter 29 is carried by the support structure 6, for example it is rigidly coupled to the support structure 6.

Preferably, the electrical contacts 30 comprise spring contacts 33 carried by the plates 7.

In particular, each plate 7 carries a printed circuit board 34 (or other forms of electrical connection), which carries the spring contacts 33, which are electrically connected to said at least one voltage meter 29 through the electrical cables 32. Conveniently, the spring contacts 33 are resilient along the third direction **Z.**

In the non-limiting embodiment shown herein, the printed circuit board 34 of each plate 7 is arranged on the first face 11 of said plate 7, on the opposite side with respect to the first projection 9. Each printed circuit board 34 preferably carries four spring contacts 33, arranged along the second direction Y, for each terminal pole 31 of each cell 2. The detection system 8 comprises one single voltage meter 29 (or a plurality of voltage meters 29), configured to measure a voltage of each cell 2 in an independent manner, to which the spring contacts 33 are electrically connected through the electrical cables 32. Conveniently, the detection system 8 comprises a detection unit 35 (schematically shown in figure 1) communicatively coupled to the voltage meter 29 and configured to detect, for each cell 2, whether a self-discharge value of said cell 2 is greater than a predetermined threshold.

Advantageously, though not in a limiting manner, the detection system 8 is configured to be able to disconnect the or some electronic components (voltage meter 29, printed circuit 34, detection unit 35) from the cell 2 during the self-discharge observation period. In this way, any passive absorption is prevented from affecting the result of the measurement.

Preferably, the apparatus 1 comprises compression means configured to bring the apparatus 1 from the first configuration to the second configuration, wherein the compression means are selected from the group comprising mechanical means, pneumatic means, electromechanical means.

In particular, the compression means are configured to bring the apparatus 1 from the first configuration, which is a rest configuration, to the second configuration, which is a compression configuration. In other words, the compression means are configured to compress the plates 7 (and therefore the cells 2) along the third direction Z.

For example, the compression means comprise mechanical means configured to exert a compressive force upon the plates 7 (and therefore upon the cells 2) by means of a mechanical actuation, in particular by means of an elastic deformation. Conveniently, the mechanical means comprise elastic means, in particular at least one spring configured to exert a return force upon the plates 7 in response to a variation in length of said at least one spring. For example, the elastic means comprise at least one compression spring configured to exert a return force upon the plates 7 in response to a decrease in length of said at least one spring.

In addition or alternatively, the compression means comprise pneumatic means configured to exert a compressive force upon the plates 7 by means of a pneumatic actuation, in particular by means of a pressure. Conveniently, the pressure is linked to the force as a function of the surface.

In addition or alternatively, the compression means comprise electromechanical means configured to exert a compressive force upon the plates 7 by means of an electrical actuation. Conveniently, the compressive force can be controlled by means of an electric drive.

In the non-limiting embodiment shown herein, the plates 7 are compressed along the third direction Z between the support plate 18 and a plate **7,** which is opposite the support plate 18 along the third direction Z. Conveniently, said plate 7 does not have the first projection 9, the second projection 10 and the electrical contacts 30 on the first face 11, but said plate 7 has the aforementioned grooves on the second face 12, so that the cell 2 facing the second face 12 can be compressed by said plate 7.

Preferably, the apparatus 1 comprises locking means configured to hold the apparatus 1 in the second configuration.

In particular, after the apparatus 1 has been brought from the first configuration, which is a rest configuration, to the second configuration, which is a compression configuration, the locking means are configured to hold the apparatus 1 in the second configuration, **i.e.** to keep the plates 7 and thus the cells 2 compressed along the third direction **Z.**

An analysis of the features of the method and of the apparatus 1 clearly reveals the advantages of the invention.

In particular, arranging the cells 2 so that a straight line L extending along the third direction Z intersects the cells **2,** compressing the cells 2 along the third direction Z and measuring a voltage of each cell 2 of the plurality of cells 2 to detect whether a self-discharge value of said cell 2 is greater than a predetermined threshold allows for the detection of possible defective cells 2, i.e. cells 2 having an abnormal self-discharge, before the cells 2 are assembled into one or more batteries or, optionally, into one or more modules of one or more batteries.

The method also allows for the detection of possible cells 2 that could show an abnormal self-discharge only after they have been assembled into one or more batteries or, optionally, into one or more modules of one or more batteries.

In particular, the method also allows for the detection of a latent metal contamination and/or latent damage to the separator, **i.e.** a metal contamination and/or damage to the separator that was already present but had not been detected, for example because it was small. Indeed, the step of compressing the cells 2 along the third direction, which anticipates the compression to which the cells 2 will be subjected when they will be assembled, involves bringing the positive and negative electrodes closer together, triggering a possible short circuit in case of latent metal contamination and/or latent damage to the separator.

The apparatus 1 easily implements the method and obtains the advantages thereof through the support structure 6**,** the plates 7 and the detection system 8.

The method and the apparatus 1 discard only the defective cells instead of discarding the entire battery (or the entire module) containing such defective cells, with evident economic and environmental advantages.

Furthermore, the method and the apparatus 1 decrease the probability of having to carry out a recall campaign, with evident economic and image advantages.

Finally, the method and the apparatus 1 can clearly be subjected to changes, though without going beyond the scope of protection set forth in the appended claims.

### LIST OF THE REFERENCE NUMBERS OF THE FIGURES

- 1: apparatus
- 2: cell
- 3: casing
- 4: first face
- 5: second face
- 6: support structure
- 7: plate
- 8: detection system
- 9: first projection
- 10: second projection
- 11: first face
- 12: second face
- 13: first element
- 14: first appendage
- 15: base
- 16: bearing element
- 17: beam
- 18: support plate
- 19: second element
- 20: second appendage
- 21: restoring means
- 22: spring
- 23: first spring
- 24: first tubular appendage
- 25: first tubular recess
- 26: second spring
- 27: second tubular appendage
- 28: second tubular recess
- 29: voltage meter
- 30: electrical contact
- 31: terminal pole
- 32: electrical cable
- 33: spring contact
- 34: printed circuit board
- 35: detection unit
- L: straight line
- X: first direction
- Y: second direction
- Z: third direction

## Claims

1. Method for monitoring self-discharge phenomena of electrochemical cells, comprising the steps of:
a) providing a plurality of electrochemical cells (2), wherein each cell (2) has a first dimension and a second dimension, extending respectively along a first direction (X) and a second direction (Y) orthogonal to each other, greater than a third dimension extending along a third direction (Z) orthogonal to the first direction (X) and the second direction (Y), wherein each cell (2) comprises a casing (3) and a plurality of layers arranged within the casing (3), wherein the layers comprise at least a first electrode layer, at least a second electrode layer and at least a first separator layer interposed between the first electrode layer and the second electrode layer;
b) arranging the cells (2) so that a straight line (L) extending along the third direction (Z) intersects the cells (2);
c) compressing the cells (2) along the third direction (Z);
d) measuring a voltage of each cell (2) of the plurality of cells (2) to detect whether a self-discharge value of said cell (2) is above a predetermined threshold,
wherein step c) is prior to or at least partially simultaneous with step d), and step d) is prior to a step of assembling the cells (2) into one or more batteries.

2. Method as claimed in claim 1, comprising a step e), prior to step c), of measuring a voltage of each cell (2) of the plurality of cells (2), wherein step d) comprises comparing the voltages measured in step e) with respective voltages measured in step d) to detect whether a self-discharge value of said cell (2) is above a predetermined threshold.

3. Method as claimed in claim 1 or 2, wherein step c) has a duration greater than a predetermined period.

4. Method as claimed in any of the preceding claims, wherein step c) comprises exerting a compressive force between a first predetermined threshold and a second predetermined threshold.

5. Method as claimed in any of the preceding claims, comprising the step of discarding each cell (2) such that the self-discharge value of said cell (2) is above said predetermined threshold.

6. Apparatus for monitoring self-discharge phenomena of electrochemical cells, comprising:
- a support structure (6);
- a plurality of plates (7) configured to carry a plurality of electrochemical cells (2), wherein each cell (2) has a first dimension and a second dimension, extending respectively along a first direction (X) and a second direction (Y) orthogonal to each other, greater than a third dimension extending along a third direction (Z) orthogonal to the first direction (X) and the second direction (Y), wherein each cell (2) comprises a casing (3) and a plurality of layers arranged within the casing (3), wherein the layers comprise at least a first electrode layer, at least a second electrode layer and at least a first separator layer interposed between the first electrode layer and the second electrode layer, wherein each plate (7) has a first dimension and a second dimension, extending respectively along said first direction (X) and said second direction (Y), greater than a third dimension extending along said third direction (Z), wherein the plates (7) are carried by the support structure (6) so that a straight line (L) extending along the third direction (Z) intersects the plates (7);
- a detection system (8) configured to measure a voltage of each cell (2) of the plurality of cells (2) to detect whether a self-discharge value of said cell (2) is above a predetermined threshold,
wherein the apparatus (1) is configured to assume a first configuration, wherein the plates (7) are not compressed along the third direction (Z), and a second configuration, wherein the plates (7) are compressed along the third direction (Z).

7. Apparatus as claimed in claim 6, wherein each plate (7) is configured to accommodate a respective cell (2) of said cells (2).

8. Apparatus as claimed in claim 7, wherein each plate (7) comprises a first projection (9) extending along the first direction (X) and a second projection (10) extending along the second direction (Y), wherein the first projection (9) and the second projection (10) are jointly configured to accommodate a respective cell (2) of said cells (2) and define the position of said cell (2) with respect to said plate (7).

9. Apparatus as claimed in any of claims 6 to 8, wherein each plate (7) is slidably coupled to the support structure (6).

10. Apparatus as claimed in claim 9, wherein the support structure (6) comprises at least a first elongated element (13) extending along the third direction (Z) and each plate (7) comprises at least a first appendage (14) slidably coupled to the first element (13).

11. Apparatus as claimed in any of claims 6 to 10, comprising restoring means (21) configured to restore the apparatus (1) from the second configuration to the first configuration.

12. Apparatus as claimed in claim 11, wherein the restoring means (21) comprise springs (22) extending along the third direction (Z) and carried by the plates (7).

13. Apparatus as claimed in any of claims 6 to 12, wherein the detection system (8) comprises at least one voltage meter (29) configured to measure a voltage of each cell (2) of the plurality of cells (2), and a plurality of electrical contacts (30) configured to be in contact with terminal poles (31) of the cells (2) and electrically connected to the at least one voltage meter (29).

14. Apparatus as claimed in claim 13, wherein said electrical contacts (30) comprise spring contacts (33) carried by the plates (7).

15. Apparatus as claimed in any of claims 6 to 14, comprising compression means configured to bring the apparatus (1) from the first configuration to the second configuration, wherein the compression means are selected from the group comprising mechanical means, pneumatic means, electromechanical means.
